# EUROPEAN PATENT SPECIFICATION

(11) **EP 1 708 263 B1**
(45) Date of publication and mention of the grant of the patent: **29.09.2010**
(21) Application number: 06007046.3
(22) Date of filing: 03.04.2006
(51) Int. Cl.: H01L 23/473, H01L 23/367

(54) **Cooling jacket**
Kühlmantel
Carter de refroidissement

(30) Priority: 01.04.2005 JP 2005105844
(43) Date of publication of application: 04.10.2006
(73) Proprietor: Hitachi, Ltd., Tokyo 100-8280 (JP)
(72) Inventor: Atarashi, Takayuki c/o Hitachi, Ltd., Chiyoda-ku Tokyo 100-8220 (JP); Nakanishi, Masato c/o Hitachi, Ltd., Chiyoda-ku Tokyo 100-8220 (JP)
(74) Representative: Beetz & Partner

(56) References cited:
- EP-A- 0 641 023
- EP-A- 1 175 135
- US-A- 4 558 395
- US-A- 5 132 780
- US-A1- 2002 070 006
- US-A1- 2003 029 601

## Description

### BACKGROUND OF THE INVENTION

The present invention relates to a cooling jacket for transmitting generated heat into a liquid refrigerant or coolant flowing inside thereof, and in particular to a cooling jacket to be used within a liquid cooling system, for enabling an effective cooling of a heat-generating element, within various kinds of electronic apparatuses wherein the heat-generating element is mounted, i.e., a semiconductor integrated circuit element, inside thereof, such as, desk-top type personal computers and servers, and notebook-type personal computers, etc.

Conventionally, electronic apparatuses such as desk-top type personal computers and servers, and notebook-type personal computers comprise semiconductor elements being a heat-generating element, such as, a CPU (Central Processing Unit), representatively, and for this reason, in general, cooling for maintaining a normal operation of the heat-generating element is necessary. Conventionally, for achieving such a cooling, there is applied, in general, a cooling system of air-cooling type, wherein a heat-transferring member, being formed with fins in one body and called "heat sink", is attached to the heat-generating element, thermally connected therewith, while providing a fan for blowing cooling air thereon.

However, in recent years, as a consequence of the tendency of small-sizing and high-integration of semiconductor integrated circuit elements, being heat-generating elements, and further with high performances thereof, heat-generation is increased in such heat-generating elements, and at the same time localization is also generated, in particular, relating to heat-generating portions thereof. For this reason, attention is paid to liquid cooling-type cooling systems having high cooling efficiency, which apply water as the coolant, for example, in place of conventional air-cooling type cooling systems, and they are actually adopted.

Such liquid cooling-type cooling systems having high cooling efficiency, to be applied to electronic apparatus, as mentioned above, which have already been known from the following Patent Documents, etc., comprise, in general, a member, being a so-called "heat-receiving jacket" or "cooling jacket", which is mounted directly on the surface of the CPU, being the heat-generation body, while running a liquid coolant within a flow passage formed inside the heat-receiving jacket. Thus, the heat generated by the CPU is transmitted into the coolant flowing within the above-mentioned jacket, thereby cooling the heat-generating body at high efficiency. However, in such a cooling system of liquid cooling type, normally, a heat cycle is built up using the cooling jacket mentioned above as a heat-receiving portion; in more details, the system comprises a circulation pump for circulating the liquid coolant within the cycle, a radiator being a heat radiation portion for radiating heat of the liquid coolant to the outside, and further a coolant tank provided in a part of the cycle, depending on the necessity thereof, for storing the liquid coolant therein, and wherein these components are connected through metal tubes or tubes made of an elastic body, such as, rubber, etc., for example.

Patent Document 1: Japanese Laid-Open Patent Application No. Hei 6-266474 (1994), and
Patent Document 2: Japanese Laid-Open Patent Application No. Hei 7-142886 (1995).

By the way, within the liquid cooling system of actively circulating the liquid coolant within the system, as was known from the prior art mentioned above, the cooling jacket for transmitting the heat from the heat-generating body into the liquid coolant, in general, has such a structure that the flow passage for the liquid coolant is formed within a housing made of a metal, such as, copper or aluminum, etc., or that a metal pipe is welded on a metal plate. However, in recent years, because of the increase of heat generation within the heat-generating element, in particular, it is strongly demanded to improve the cooling capacity thereof, and for example: an electrical fan is further attached to the radiator, so as to forcedly accelerate heat radiation. However, it cannot be said that sufficient improvements have been made regarding an improvement of the cooling jacket, in particular, the heat conduction thereof.

Thus, as is apparent from the prior art mentioned above, in the cooling jacket of the conventional art, the liquid coolant cooled down in the radiator flows into the flow passage formed within the metal housing thereof. In that instance, on the base portion of the cooling jacket (i.e., a metal plate portion to be in contact with a surface of the heat-generating element), the heat generated from a LSI, for example, is transferred into the liquid coolant through diffusion thereof; however, with the cooling jacket having such a conventional structure, since the base portion thereof has only a plural number of wall portions, which are formed on a metal plane plate, for enlarging the area being in contact with the liquid coolant, therefore the heat can diffuse in the direction of the plane on the metal plate, but it has such a structure that the heat can hardly diffuse into the vertical direction (i.e., into the wall portions) . Thus, with the cooling jacket of the conventional art, the heat cannot be transferred effectively from the wall portions to the liquid coolant, even if the area being in contact with the liquid coolant is enlarged by means of the wall portions, and therefore, it has a large heat resistance. For this reason, there is the drawback that it is not always possible to obtain a sufficient cooling capacity therewith.

US 2002/070006 shows a heat exchanger provided for heat transfer using a liquid coolant. The heat exchanger is a planar body which may be sandwiched between two semiconductor devices. The heat exchanger is built from a bottom part and a top part comprising an inlet port and an outlet port for the liquid coolant.

US 4 558 395 shows a cooling member which includes a cooling block having fins therein and having space for causing the coolant to flow between those fins. The fins may be formed as a part of the cooling block, or may be formed integrally with the upper cover or lower cover of the cooling block and then may be fixed to the bottom face or the internal face of the upper cover of the cooling block. On the upper surface of the cooling block, a pair of pipes for causing the coolant to flow into or out of the inside of the block are provided.

### BRIEF SUMMARY OF THE INVENTION

The present invention is accomplished by taking such drawbacks into consideration; in more detail, it is an object to provide a cooling jacket, reducing the heat resistance through an improvement on the heat transfer from the heat-generating element, and thereby being superior in its cooling capacity.

The above problem is solved according to the independent claims. The dependent claims relate to preferred embodiments of the invention.

For accomplishing the object mentioned above, according to the present invention, there is provided a cooling jacket for cooling a heat-generating element through transmission of the heat generated therein into a liquid coolant, which is to be mounted within an electronic apparatus, comprising
- a base portion which comprises:
   - a lower surface which is a heat transfer surface to be in contact with a surface of the heat-generating element,
   - an elongated projecting portion provided on the upper surface of the base portion and extending in a longitudinal horizontal direction and also in the vertical direction perpendicular to the heat transfer surface and comprising a plural number of wail portions extending on both sides of the projecting portion in a direction perpendicular to the heat-transfer surface and perpendicular to the projecting portion parallel to and at a distance from each other, thereby defining flow passages for the liquid coolant therebetween,
- a cover portion attached to the upper portion of the base portion along its periphery in a liquid-tight manner, and
- an inlet pipe for introducing the liquid coolant and an outlet pipe for discharging the liquid coolant, wherein
- the base portion comprises one single projecting portion extending in the longitudinal horizontal direction from the center of the heat transfer surface,
- the cover portion:
   - is shaped into a box-like configuration,
   - comprises one or two inlet pipes and one or two outlet pipes, and
   - either comprises a lateral lower guide portion on each side extending in
   - longitudinal direction, and the inlet pipe is attached in the front side of one of the lower guide portions, and the outlet pipe is attached in the back side of the other lower guide portion,
   - or comprises a lateral guide portion, on each side extending in longitudinal direction and an upper guide portion extending in longitudinal direction, and the inlet pipe is attached to the upper guide portion, and an outlet pipe is attached to each of the lateral guide portions, the flow direction of the liquid coolant being reversible.

### BRIEF DESCRIPTION OF THE DRAWINGS

Those and other objects, features and advantages of the present invention will become more readily apparent from the following detailed description when taken in conjunction with the accompanying drawings wherein:
Fig. 1 is an exploded perspective view for showing the entire structure of a cooling jacket according to an embodiment of the present invention,
Fig. 2 is a view for explaining the heat diffusion of a heat-generating body within the cooling jacket mentioned above, and
Fig. 3 is an exploded perspective view for showing the entire structure of a cooling jacket according to another embodiment of the present invention.

### DETAILED DESCRIPTION OF THE INVENTION

Hereinafter, embodiments according to the present invention will be fully explained by referring to the attached drawings.

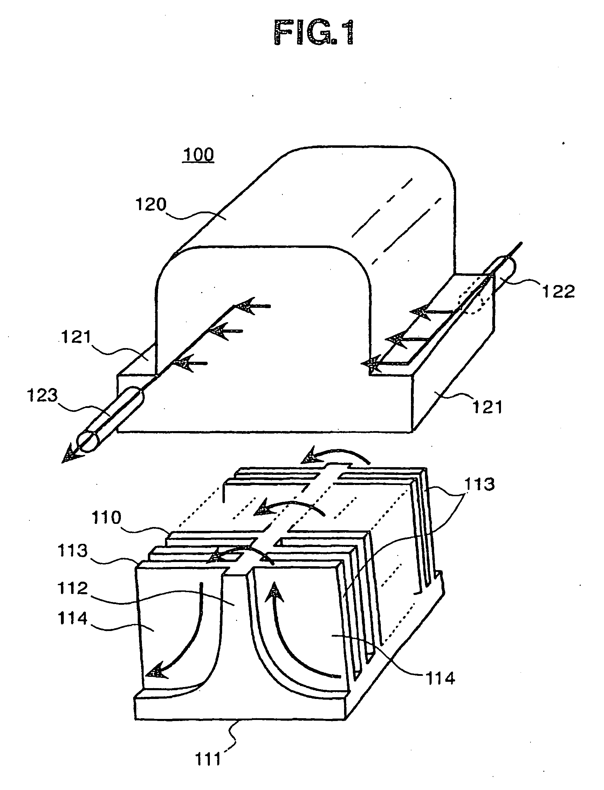

First of all, Fig. 1 attached herewith shows the structure of a cooling jacket according to an embodiment of the present invention through the exploded perspective view thereof. This cooling jacket builds up a part of a so-called liquid cooling system together with a radiator, a driving pump, and a tank, etc., though not shown herein, within an electronic apparatus including the heat-generating element (for example, a CPU, etc.) inside a housing, such as, a desk-top type personal computer, a server, a notebook-type personal computer, etc., for example. Further, those constituent parts are connected through metal tubes or the like, and in the inside thereof is enclosed a liquid refrigerant or coolant, such as, water and/or ethylene glycol, for example.

The cooling jacket 100 according to the present invention, as is apparent from the figure, has a base portion 110, which is made of a metal, such as, copper or aluminum, etc., for example, being superior in the heat conductivity, and a cover portion 120 for covering the base portion 110, surrounding the periphery thereof. Further, this base portion 110 build sup a heat-transfer surface 111 on the lower surface thereof, to be in contact with a surface of the heat-generating element, such as the CPU mentioned above, through a heat-conductive grease or paste or the like. This base portion 110 includes a solid (or an inside) portion having summit portions 112 at the central portion thereof, and building up a plural number of wall portions 113, extending into directions perpendicular to the heat-transfer surface 111 and also perpendicular to the summit portions 112. And, as is apparent from the figure, between those plural numbers of wall portions 113 are defined flow passages 114, each having a sector or a fan-like shape, approximately, in a large number thereof, while being piled up in the direction of the summit portion 112.

On the other hand, onto the base portion 110 will be attached the cover portion 120, which is shaped, approximately, into a box-like outer configuration, so that it surrounds the periphery of the base portion 110 from the upper portion thereof. Further, at portions of the cover portion 120 (in front and back of a lower guide portion 121) are attached an inlet pipe 122 for introducing the liquid coolant and an outlet pipe 123 for discharging the coolant to the outside. Further, the cover portion 120 is attached onto the base portion 110 in a liquid-tight manner. For this reason, the liquid coolant running therein from the inlet pipe 122, as is shown by arrows in Fig. 1, passes through the fan-shaped flow passages 114, each of which is defined between the wall portion 113, from the guide portion 121 and is collected in the upper portion of the cover portion 120. Thereafter, passing through the fan-shaped passages 114, each of which is defined between other wall portions 113 (i.e., on the left-hand side in the figure), it reaches the guide portion 121 and is discharged from the outlet pipe 123 to the outside.

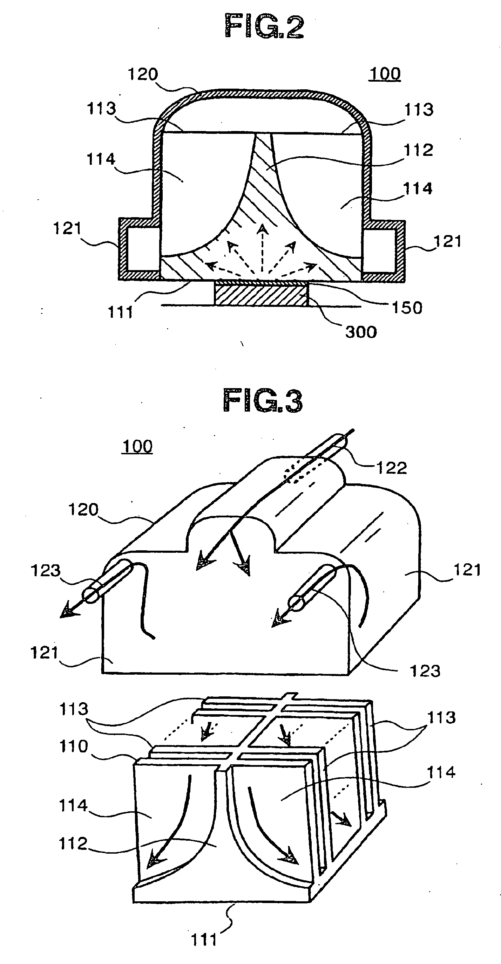

In this instance, as is shown in Fig. 2, the heat-transfer surface 111 of the base portion 110 is in contact with an LSI chip 300 being the heat-generating body. A heat-conductive grease 150 or paste or the like having a superior heat-conductivity is provided there between for thermal connection. Therefore, heat generated from this heat-generating body 300 can diffuse, not only in the horizontal direction along the heat-transfer surface 111 of the base portion 110, but also in the direction towards the summit portion 112 of the base portion 110 (i.e., the vertical direction), too (see arrows with broken lines in the Fig. 2). Thus, with such a structure of the base portion 110 as was mentioned above, it is possible to diffuse the heat of the heat-generating body 300, which is disposed on the heat-transfer surface in contact therewith, isotropically and into various directions, thereby achieving an effective heat transfer into the liquid coolant flowing between the walls through the wall portions 113. For this reason, it is possible to lower the heat resistance within the base portion 110, thereby enabling to increase the efficiency of the cooling jacket 100 considerably.

However, when it is considered to increase the isotropic heat diffusion from the heat-transfer surface and also the surface area of the wall portions as much as possible in the structures mentioned above, it is preferable that the solid portion (i.e., the hatched portion) of the base portion is extended or elongated with respect to the heat-transfer surface 111, i.e., into the horizontal direction and also the vertical direction from the center of the heat-transfer surface, and further that the width thereof is gradually reducing with increasing distance from the center of the respective heat-transfer surfaces. However, it may be more simplified in its configuration (for example, the width of the respective solid portions becomes linearly smaller with increasing distance from the heat-transfer surface (such that the flow passage 114 is of about triangular shape), or being of constant width without change (such that the flow passage is of rectangular shape)), and also in such cases there can be obtained a similar effect as that mentioned above.

Fig. 3 shows the structure of the cooling jacket according to another embodiment of the present invention. In this further embodiment, differing from that shown in Fig. 1, the inlet pipe 122 is attached on an upper portion of the cover portion 120, and the liquid coolant flows from the summit portion 112 of the base portion 110 into the fan-like shaped flow passages 114, which are made up on both sides thereof.

The liquid coolant passing through the fan-like shaped flow passages 114, which are made up on both sides of the base portion 110, is discharged thereafter to the outside, from the outlet pipes 123, which are attached on both sides of the cover portion 120 (see arrows in Fig. 3). However, also with the cooling jacket according to that further embodiment, as it is similar to that of the embodiment mentioned above, the base portion 110 achieves the similar function because of its structure, i.e., diffusing the heat from the heat-generating body 300, which is disposed on the heat-transfer surface in contact therewith, isotropically. Therefore, it is possible to lower the heat resistance within the base portion 110, thereby enabling to increase the efficiency of the cooling jacket 100 considerably. It is further possible to reverse the flow direction of the liquid coolant so that it flows from the lower portions on both sides of the cover portion 120 to the upper portion, and a similar effect can be achieved.

The solid portion (i.e., the hatched portion) of the base portion is preferably elongated with respect to the heat-transfer surface 111, i.e., in the horizontal direction and also the vertical direction from the center of the heat-transfer surface, and further, the width thereof becomes gradually smaller with increasing distance from the center of the respective heat-transfer surfaces (i.e., the fan-like flow passages). However, it is needless to say that the configuration may be more simplified (for example, the width of the respective solid portions is becoming linearly smaller with increasing distance from the heat-transfer surface, or the width remains constant without change), and there can be obtained a similar effect as in the cases explained above.

## Claims

1. Cooling jacket (100) for cooling a heat-generating element (300) through transmission of the heat generated therein into a liquid coolant,
which is to be mounted within an electronic apparatus, comprising
- a base portion (110) which comprises
• a lower surface which is a heat transfer surface (111) to be in contact with a surface of the heat-generating element (300), an elongated projecting portion (112) provided on the upper surface of the base portion (110) and extending in a longitudinal horizontal direction and also in the vertical direction perpendicular to the heat transfer surface (111) and comprising a plural number of wall portions (113) extending on both sides of the projecting portion (112) in a direction perpendicular to the heat-transfer surface (111) and perpendicular to the projecting portion (112)parallel to and at a distance from each other, thereby defining flow passages (114) for the liquid coolant therebetween,
- a cover portion (120) attached to the upper portion of the base portion (110) along its periphery in a liquid-tight manner, and
- an inlet pipe (122) for introducing the liquid coolant and an cutlet pipe (123) for discharging the liquid coolant, **characterized in that**
- the base portion (110) comprises one single projecting portion (112) extending in the longitudinal horizontal direction from the center of the heat transfer surface (111),
- the cover portion (120)
• is shaped into a box-like configuration,
• comprises one or two inlet pipes (122) and one or two outlet pipes (123),
and
• either comprises a lateral lower guide portion (121) on each side extending in longitudinal direction, and the inlet pipe (122) is attached in the front side of one of the lower guide portions (121), and the outlet pipe (123) is attached in the back side of the other lower guide portion (121) (Fig. 1),
• or comprises a lateral guide portion (121) on each side extending in longitudinal direction and an upper guide portion extending in longitudinal direction,
and the inlet pipe (122) is attached to the upper guide portion, and
an outlet pipe (123) is attached to each of the lateral guide portions (121),
the flow direction of the liquid coolant being reversible (Figs. 2, 3).

2. Cooling jacket (100) according to claim 1, **characterized in that** the width of the projecting portion (112) of the base portion (110) is gradually becoming smaller in the vertical direction to the end thereof.

3. Cooling jacket (100) according to claim 2, **characterized in that** the width of the projecting portion (112) is becoming linearly smaller in the vertical direction to the end thereof such that the flow passages (114) are of about triangular shape.

4. Cooling jacket (100) according to claim 2, **characterized in that** the width of the projecting portion (112) is of a summit-like shape such that the flow passages (114) are of sector-like shape.

5. Cooling jacket (100) according to claim 1, **characterized in that** the width of the projecting portion (112) of the base portion (110) is constant in the vertical direction such that the flow passages (114) are of rectangular shape.

## Patentansprüche

1. Kühlmantel (100) zum Kühlen eines wärmeerzeugenden Elements (300) durch Übertragung der darin erzeugten Wärme in ein flüssiges Kühlmittel,
der in einer elektronischen Vorrichtung anzubringen ist und der aufweist:
- einen unteren Teil (110), der aufweist:
• eine untere Fläche, die eine Wärmeübertragungsfläche (111) darstellt, die mit einer Oberfläche eines wärmeerzeugenden Elements (300) in Kontakt zu bringen ist,
• einen länglichen vorstehenden Abschnitt (112), der auf der oberen Fläche des unteren Teils (110) vorgesehen ist und sich in einer horizontalen Längsrichtung sowie in der vertikalen Richtung senkrecht zur Wärmeübertragungsfläche (111) erstreckt und mehrere Wandabschnitte (113) aufweist, die sich auf beiden Seiten des vorstehenden Abschnitts (112) in einer Richtung senkrecht zur Wärmeübertragungsfläche (111) und senkrecht zum vorstehenden Abschnitt (112) parallel zueinander und voneinander beabstandet erstrecken, wodurch Strömungswege (114) für das flüssige Kühlmittel dazwischen vorgegeben werden,
- einen oberen Teil (120), der am oberen Abschnitt des unteren Teils (110) längs seines Umfangs flüssigkeitsdicht angebracht ist,
und
- ein Eintrittsrohr (122) zur Einführung des flüssigen Kühlmittels und ein Austrittsrohr (123) zur Abführung des flüssigen Kühlmittels,
**dadurch gekennzeichnet, dass**
- der untere Teil (110) einen einzigen vorstehenden Abschnitt (112) aufweist, der sich von der Mitte der Wärmeübertragungsfläche (111) aus in der horizontalen Längsrichtung erstreckt,
und
- der obere Teil (120)
• in einer kastenartigen Form ausgebildet ist,
• ein oder zwei Eintrittsrohre (122) und ein oder zwei Austrittsrohre (123) aufweist
und
• entweder einen seitlichen unteren Führungsabschnitt (121) aufweist, der sich auf jeder Seite in Längsrichtung erstreckt, wobei das Eintrittsrohr (122) auf der Vorderseite eines der unteren Führungsabschnitte angebracht ist und das Austrittsrohr (123) auf der Rückseite des anderen unteren Führungsabschnitts (121) angebracht ist (Fig. 1),
• oder auf jeder Seite einen seitlichen Führungsabschnitt (121), der sich in Längsrichtung erstreckt, und einen oberen Führungsabschnitt aufweist, der sich in Längsrichtung erstreckt, wobei das Eintrittsrohr (122) am oberen Führungsabschnitt angebracht ist
und
ein Austrittsrohr (123) an jedem der seitlichen Führungsabschnitte (121) angebracht ist,
wobei die Strömungsrichtung des flüssigen Kühlmittels umkehrbar ist (Figuren 2, 3).

2. Kühlmantel (100) nach Anspruch 1, **dadurch gekennzeichnet, dass** die Breite des vorstehenden Abschnitts (112) des unteren Teils (110) in der vertikalen Richtung zu seinem Ende hin allmählich kleiner wird.

3. Kühlmantel (100) nach Anspruch 2, **dadurch gekennzeichnet, dass** die Breite des vorstehenden Teils (112) in der vertikalen Richtung zu seinem Ende hin linear kleiner wird, sodass die Strömungswege (114) etwa dreieckige Form besitzen.

4. Kühlmantel (100) nach Anspruch 2, **dadurch gekennzeichnet, dass** die Breite des vorstehenden Abschnitts (112) eine kuppenartige Form besitzt, sodass die Strömungswege (114) sektorartige Form aufweisen.

5. Kühlmantel (100) nach Anspruch 1, **dadurch gekennzeichnet, dass** die Breite des vorstehenden Abschnitts (112) des unteren Teils (110) in der vertikalen Richtung konstant ist, sodass die Strömungswege (114) rechteckige Form besitzen.

## Revendications

1. Chemise de refroidissement (100) conçu pour refroidir un élément générateur de chaleur (300) par transmission de la chaleur qui y est générée dans un liquide de refroidissement,
qui doit être installée à l'intérieur d'un appareil électronique comprenant :
- une partie base (110) qui comprend
• une surface inférieure qui est une surface de transfert thermique (111) devant être en contact avec une surface de l'élément générateur de chaleur (300),
• une partie saillante allongée (112) prévue sur la surface supérieure de la partie base (110) et s'étendant dans une direction horizontale longitudinale et aussi dans la direction verticale perpendiculaire à la surface de transfert thermique (111) et comprenant une pluralité de parties de paroi (113) s'étendant des deux côtés de la partie saillante (112) dans une direction perpendiculaire à la surface de transfert thermique (111) et perpendiculaire à la partie saillante (112), qui sont parallèles et situées à une certaine distance l'une de l'autre, ce qui permet de définir des passages d'écoulement (114) pour le liquide de refroidissement entre les deux,
- une partie couverture (120) fixée à la partie supérieure de la partie base (110) le long de sa périphérie d'une manière étanche au liquide, et
- un tuyau d'admission (122) pour introduire le liquide de refroidissement et un tuyau d'évacuation (123) pour évacuer le liquide de refroidissement,
**caractérisée en ce que**
- la partie base (110) comprend une unique partie saillante (112) s'étendant dans la direction longitudinale horizontale depuis le centre de la surface de transfert thermique (111),
- la partie couverture (120)
• est formée en une configuration de type boîtier,
• comprend un ou deux tuyaux d'admission (122) et un ou deux tuyaux d'évacuation (123),
et
• soit comprend une partie de guidage inférieure latérale (121) sur chaque côté s'étendant dans la direction longitudinale et le tuyau d'admission (122) est fixé sur le côté avant d'une des parties de guidage inférieures (121) et le tuyau d'évacuation (123) est fixé au côté arrière de l'autre partie de guidage inférieure (121) (figure 1),
• soit comprend une partie de guidage latérale (121) sur chaque côté s'étendant dans la direction longitudinale et une partie de guidage supérieure s'étendant dans la direction longitudinale,
et le tuyau d'admission (122) est fixé à la partie de guidage supérieure, et
un tuyau d'évacuation (123) est fixé à chacune des parties de guidage latérales (121),
la direction d'écoulement du liquide de refroidissement étant réversible (figures 2, 3).

2. Chemise de refroidissement (100) selon la revendication 1, **caractérisée en ce que** la largeur de la partie saillante (112) de la partie base (110) devient graduellement plus petite dans la direction verticale vers l'extrémité de celle-ci.

3. Chemise de refroidissement (100) selon la revendication 2, **caractérisée en ce que** la largeur de la partie saillante (112) devient linéairement plus petite dans la direction verticale vers l'extrémité de celle-ci de sorte que les passages d'écoulement (114) se présentent de forme à peu près triangulaire.

4. Chemise de refroidissement (100) selon la revendication 2, **caractérisée en ce que** la largeur de la partie saillante (112) prend la forme d'un sommet de telle sorte que les passages d'écoulement (114) se présentent comme des secteurs.

5. Chemise de refroidissement (100) selon la revendication 1, **caractérisée en ce que** la largeur de la partie saillante (112) de la partie base (110) est constante dans la direction verticale de sorte que les passages d'écoulement (114) se présentent sous une forme rectangulaire.
